# EUROPÄISCHE PATENTSCHRIFT

(11) **EP 2 062 019 B1**
(45) Veröffentlichungstag und Bekanntmachung des Hinweises auf die Patenterteilung: **06.02.2019**
(21) Anmeldenummer: 07801502.1
(22) Anmeldetag: 03.08.2007
(51) Int. Cl.: G01J 9/00, G02B 27/46, G03F 1/84

(54) **VERFAHREN UND VORRICHTUNG ZUR ORTSAUFGELÖSTEN BESTIMMUNG DER PHASE UND AMPLITUDE DES ELEKTROMAGNETISCHEN FELDES IN DER BILDEBENE EINER ABBILDUNG EINES OBJEKTES**
METHOD AND APPARATUS FOR THE SPATIALLY RESOLVED DETERMINATION OF THE PHASE AND AMPLITUDE OF THE ELECTROMAGNETIC FIELD IN THE IMAGE PLANE OF AN IMAGE OF AN OBJECT
PROCÉDÉ ET DISPOSITIF DE DÉTERMINATION À RÉSOLUTION LOCALE DE LA PHASE ET DE L'AMPLITUDE D'UN CHAMP ÉLECTROMAGNÉTIQUE DANS LE PLAN D'IMAGE D'UNE REPRÉSENTATION D'UN OBJET

(30) Priorität: 31.08.2006 DE 102006041496; 21.02.2007 DE 102007009661
(43) Veröffentlichungstag der Anmeldung: 27.05.2009
(73) Patentinhaber: Carl Zeiss SMT GmbH, 73447 Oberkochen (DE)
(72) Erfinder: PERLITZ, Sascha, 07743 Jena (DE); WEISSENBERG, Steffen, 04105 Leipzig (DE); FÖRSTER, Sandro, 73479 Ellwangen (DE); SCHERÜBL, Thomas, 07745 Jena (DE); MATEJKA, Ulrich, 07743 Jena (DE); GROSS, Herbert, 73457 Essingen (DE)
(74) Vertreter: Patentanwälte Geyer, Fehners & Partner mbB
(86) Internationale Anmeldenummer: PCT/EP2007/006873
(87) Internationale Veröffentlichungsnummer: WO 2008/025433

(56) Entgegenhaltungen:
- WO-A-91/07682
- WO-A-03/034010
- US-A1- 2003 137 654
- US-A1- 2003 202 634
- IVANOV V Y ET AL: "Phase retrieval from a set of intensity measurements: theory and experiment" JOURNAL OF THE OPTICAL SOCIETY OF AMERICA A (OPTICS AND IMAGE SCIENCE) USA, Bd. 9, Nr. 9, September 1992 (1992-09), Seiten 1515-1524, XP002466580 ISSN: 0740-3232
- REDDING D C ET AL: "Wavefront sensing and control for large space optics" AEROSPACE CONFERENCE, 2003. PROCEEDINGS. 2003 IEEE MARCH 8-15, 2003, PISCATAWAY, NJ, USA,IEEE, Bd. 4, 8. März 2003 (2003-03-08), Seiten 41729-41744, XP010660400 ISBN: 0-7803-7651-X

## Beschreibung

### Gebiet der Erfindung

Die Erfindung betrifft ein Verfahren zur ortsaufgelösten Bestimmung der Phase und Amplitude des elektromagnetischen Feldes in der Bildebene einer Abbildung eines Objektes, bei dem Bilder erzeugt werden, indem (a) das Objekt mit kohärentem Licht einer Beleuchtungseinrichtung beleuchtet und in eine Bildebene abgebildet wird, (b) Licht in der Bildebene ortsaufgelöst in Pixeln detektiert wird, (c) wobei für jedes Pixel die Intensität des Lichts bestimmt, in Bildpunkten gespeichert wird und die Bildpunkte einem Bild zugeordnet werden. Dabei wird zunächst ein erstes Bild erzeugt. Dann wird mindestens ein weiteres Bild erzeugt, wobei die Phase und/oder die Amplitude des Lichts in vorgegebener Weise modifiziert werden und die Modifikation sich für ein jedes Bild von denen für die übrigen Bilder unterscheidet. Das erste Bild wird dabei in der Regel ohne jede Modifikation aufgenommen. Aus den erzeugten Bildern wird dann ortsaufgelöst die Phase in der Abbildung des Objekts in der Bildebene bestimmt.

Die Erfindung betrifft auch eine Vorrichtung zur ortsaufgelösten Bestimmung der Phase und Amplitude des elektromagnetischen Feldes in der Bildebene einer Abbildung eines Objektes. Eine solche Vorrichtung umfaßt eine Beleuchtungseinrichtung mit einer kohärentes Licht abstrahlenden Lichtquelle, einen Halter für das Objekt, eine Abbildungsoptik, einen ortsauflösenden Detektor mit Pixeln, ein Speichermodul sowie ein Auswertemodul. Die Vorrichtung erzeugt Bilder, indem (a) das Objekt mit dem kohärenten Licht beleuchtet und durch die Abbildungsoptik in die Bildebene abgebildet wird, (b) das Licht in der Bildebene ortsaufgelöst in den Pixeln detektiert wird, (c) wobei für jedes Pixel die Intensität des Lichts bestimmt und im Speichermodul in Bildpunkten gespeichert wird, und die Bildpunkte einem Bild zugeordnet werden.

### Stand der Technik

Zur Bestimmung der Phase der Wellenfront bei einer Abbildung eines unbekannten Objektes, welches mit kohärentem Licht bestrahlt wird, existieren im Stand der Technik verschiedene Methoden. Dabei handelt es sich in der Regel um die iterativen Methoden, bei denen die Phase in der Abbildung bzw. die Wellenfront in der Abbildung aus zwei oder mehr ortsaufgelösten Intensitätsmessungen iterativ rekonstruiert wird. Die Intensitätsmessungen unterscheiden sich dabei in vorgegebener, wohldefinierter Weise. So kann beispielsweise ein erstes Bild aufgenommen werden, bei dem sich Objekt und ortsauflösender Detektor jeweils in der Fokusposition der abbildenden Optik befinden. Ein zweites Bild kann dann aufgenommen werden, indem eine gezielte Defokussierung vorgenommen wird. Ist das Objekt auf einem Halter angebracht, so kann dieser Halter entlang der optischen Achse um eine definierte Strecke verschoben werden. Alternativ und äquivalent kann auch der Detektor verschoben werden, wobei die Verschiebung entsprechend größer ausfällt, je stärker die Vergrößerung der abbildenden Optik ist. Im Detektor wird das einfallende Licht registriert und in Intensitätswerte umgewandelt. Die unter gleichen Aufnahmebedingungen und zur gleichen Zeit registrierten Intensitätswerte werden in Bildpunkten gespeichert und zu einem Bild zusammengefaßt. Aus diesen mindestens zwei Bildern läßt sich dann mittels sogenannter Phase-Retrieval-Algorithmen die Phase bzw. Wellenfront des vom Objekt kommenden Lichts bei der Abbildung in die im Fokus befindliche Bildebene berechnen. Zu den am häufigsten verwendeten Phase-Retrieval-Algorithmen gehören die Familien der sogenannten Gerchberg-Saxton-Algorithmen (R. B. Gerchberg, W. O. Saxton, Optik, Band 35, Seite 237, 1972) oder Yang-Gu-Algorithmen (G. Yang, Applied Optics, Band 33, Seite 209, 1994).

Zwar reichen grundsätzlich zwei Bilder aus, um die Phase zu berechnen, jedoch dauert die Iteration u.U. sehr lange. Aus diesem Grund ist es wünschenswert, möglichst viele Bilder aufzunehmen, wobei dann einige Informationen zwar redundant sind, jedoch letzten Endes eine höhere Genauigkeit erzielt werden kann. Generiert man verschiedene Bilder nur auf Basis einer Defokussierung, so stößt man schnell an die Grenzen, da die Defokussierung nur in einem begrenzten Verstellungsbereich möglich ist und die Bilder ansonsten zu verwaschen sind, um noch vernünftig ausgewertet werden zu können.

In der Mikroskopie andererseits sind Verfahren bekannt, mit denen der Phasenkontrast bei der Abbildung erhöht werden kann. Bei solchen Verfahren werden die nicht sichtbaren, geringen Phasenänderungen, die das Licht in oder an mikroskopischen oder makroskopischen Objekten erleidet, in Intensitätsänderungen umgewandelt. Auf diese Weise werden sie sichtbar gemacht. Dies wird erreicht, indem bei der Abbildung dieser Objekte das ungebeugte Licht gegenüber dem am Objekt gebeugten Licht in der Phase und Amplitude verändert wird, wobei in das Beugungsspektrum des Objektes in einer Pupillenebene eingegriffen wird. Dabei macht man sich zunutze, daß Mikroskopobjektive näherungsweise wie Fourier-Transformations-Optiken aufgebaut sind, so daß in einer Pupillenebene der Abbildungsoptik gezielte Eingriffe in das Ortsfrequenzspektrum der Intensitätsverteilung des vom Objekt gebeugten Lichtes möglich sind.

Ein Mikroskop, mit dem die Bestimmung der Phase und Amplitude des elektromagnetischen Feldes in der Bildebene der Abbildung eines Objektes möglich ist, wird in der WO 91/07682 offenbart. Dort wird ein konfokales Laser-Scanning-Mikroskop beschrieben, bei dem ein Laserstrahl auf einen kleinen Teil eines Objektes fokussiert wird. Licht von diesem Teil des Objekts wird über ein Pinhole auf einen Detektor abgebildet. Ein erstes Bild wird aufgenommen, indem das Objekt ohne Eingriffe beleuchtet wird. Für das zweite Bild wird in den Strahlengang in zwei Pupillenebenen ein Filter jeweils vor und hinter dem Objekt eingebracht. Die beiden Filter haben dabei eine intensitätsverändernde bzw. amplitudenverändernde Funktion entsprechend einer vorgegebenen mathematischen Funktion, deren Eigenschaften die Auswertung vereinfacht, wenn sowohl auf der Beleuchtungs-, als auch auf der Abbildungsseite ein Filter verwendet wird. Für den kleinen Teil des Objekts läßt sich dann die Phase im Bild berechnen. Da das Licht über ein Pinhole auf einen Detektor abgebildet wird, ist eine ortsaufgelöste Messung umständlich und langwierig. Auch die Verwendung der beiden Filter, die aneinander angepaßt sein müssen, ist umständlich. Weitere Verfahren sind aus XP002466580 ("Phase retrieval from a set of intensity measurements: theory and experiment", JOURNAL OF THE OPTICAL SOCIETY OF AMERICA, 1992, V. Yu Ivanov et al.), XP010660400 ("Wavefront sensing and control for large space optics", Aerospace Conference Proceedings, 2003, David C. Redding et al.) und US2003202634 bekannt.

### Beschreibung der Erfindung

Aufgabe der Erfindung ist es, ein Verfahren zu entwickeln, mit dem eine einfache ortsaufgelöste Bestimmung der Phase in der Abbildung eines Objektes möglich ist. Außerdem soll eine Vorrichtung entwickelt werden, die das Verfahren auf einfache Weise umsetzt und ein hohes Maß an Flexibilität für die Aufnahme von Bildern unter verschiedenen Bedingungen ermöglicht.

Diese Aufgabe wird bei einem Verfahren der eingangs beschriebenen Art dadurch gelöst, daß die Phase und/oder die Amplitude des Lichts durch eine Ortsfrequenzfilterung in einer Pupillenebene zwischen Objekt und Bildebene modifiziert wird. Im Gegensatz zu dem oben beschriebenen Mikroskop muß die Filterung nur einmal durchgeführt werden. Eine Ortsfrequenzfilterung bietet darüber hinaus gegenüber einer Defokussierung mehr Möglichkeiten, so daß Bilder unter verschiedenen Bedingungen aufgenommen werden können, was die Genauigkeit des Verfahrens erheblich verbessert und weitere Anwendungsmöglichkeiten gestattet. Die Modifikation ist dabei genau vorgegeben. Sie unterscheidet sich für alle Bilder, so daß man in einem Satz verschiedene Intensitätsbilder erhält. Mindestens jedoch werden zwei Bilder aufgenommen. Dabei können alle Bilder mit Ortsfrequenzfilterung erzeugt werden. Alternativ kann auch eines der Bilder ohne Filterung erzeugt werden. Dies spielt für die Bestimmung der Phase keine Rolle, bietet jedoch u.U. Vorteile für die Nachbearbeitung. Aus dem aufgenommenen Bilddatensatz läßt sich dann durch ein iteratives Verfahren - beispielsweise einen Algorithmus aus der Gerchberg-Saxton-Familie - auf die Phase im Bildraum und damit auf die durch den Abbildungsprozeß beschränkte Phase im Objektraum zurückrechnen. Der wesentliche Vorteil der Ortsfrequenzfilterung liegt in der völlig freien Wahl der frequenzselektiven Manipulation. Auf diese Weise ist es möglich, die Nachteile der Defokussierung, welche bei der Phasenmodulation hochfrequente Bildanteile viel stärker beeinflußt, zu kompensieren. Durch eine Ortsfrequenzfilterung sind auch wesentlich genauere Phasenrekonstruktionen mit geringerem Rechenaufwand möglich.

Die Ortsfrequenzfilterung wird durch Einbringen eines Ortsfrequenzfilters vorgenommen. Die Eigenschaften dieses Ortsfrequenzfilters sind dabei vorbekannt, da sie in den Phase-Retrieval-Algorithmus als Parameter eingehen. Selbstverständlich können auch mehrere Ortsfrequenzfilter gleichzeitig verwendet werden, wobei beispielsweise ein erster Filter einen ersten Frequenzbereich und ein zweiter Filter einen zweiten Frequenzbereich abdeckt. Auch kann ein erster Filter als Amplitudenfilter und ein zweiter Filter als Phasenfilter ausgestaltet sein. Möglich ist auch die Kombination von Phasen- und Amplitudenfilter in einem einzigen Filter. Zur Modifikation von Phase und/oder Amplitude wird der Ortsfrequenzfilter gemäß der Erfindung im Strahlengang um die optische Achse und/oder um eine zur optischen Achse senkrechte Drehachse, die die optische Achse schneidet, gedreht, und/oder senkrecht zur optischen Achse verschoben. Auf diese Weise kann die Phase bzw. die Amplitude des Lichtes auf vielfache Weise mit ein und demselben Element modifiziert werden.

Als Ortsfrequenzfilter kann beispielsweise eine Einzellinse, ein Mikrolinsen-Array, ein Siemensstern, Spiralfilter, ein Transmissionsgitter oder auch ein Phasengitter verwendet werden. Diese Filter können auch in Kombination eingesetzt werden. Insbesondere einzelne Linsen oder Mikrolinsenarrays sind besonderes gut geeignet, da sie die nullte Beugungsordnung nicht ausblenden. Auch Sinus-Schachbrett-Gitter weisen diesen Vorteil auf.

Eine vielfältige Manipulationsmöglichkeit - bei meist symmetrischen Beugungsspektren - erhält man, wenn die Positionen der Einzellinsen auf dem Array nicht regelmäßig, sonder statistisch gestreut und / oder aperiodisch verteilt sind.

Zweckmäßig ist es auch, vor der ortsaufgelösten Bestimmung der Phase eine Kalibrierung des Ortsfrequenzfilters durchzuführen. Dies erhöht die Genauigkeit. Zur Kalibrierung des Ortsfrequenzfilters wird ein Objekt, dessen Abbildungseigenschaften bekannt sind, verwendet. Zur Phasenmanipulation wird dann entweder ausschließlich eine Defokussierung oder eine Verschiebung des Filters entlang der optischen Achse durchgeführt. In beiden Fällen läßt sich nach Durchlauf durch den Phase-Retrieval-Algorithmus auf die Phasen- und Amplitudenmanipulation durch den Ortsfrequenzfilter schließen.

In einer besonders bevorzugten Ausgestaltung des Verfahrens wird in den Strahlengang in einer Objektebene der Beleuchtungseinrichtung eine Leuchtfeldblende eingebracht. Zwar wird in der Regel eine mikroskopische Abbildungsoptik verwendet, die sich in erster Näherung wie eine Fourier-Transformations-Optik verhält, diese Näherung wird durch das Einbringen der Leuchtfeldblende weiter verbessert, da auf diese Weise störende Randeffekte, die durch die periodische Fortsetzung des Beugungsspektrums entstehen, minimiert werden können. Durch die Leuchtfeldblende läßt sich erreichen, daß abbildungskonform zum Rand des Detektors ein Intensitätsabfall auf Null erfolgt. Als Abbildungsmodell kann dann die Fourier-Transformation - die eine periodische Fortsetzung des Bildes impliziert - verwendet werden, ohne daß am Rand Intensitätssprünge entstehen, die durch Ortsfrequenzartefakte verursacht werden. Vorteilhaft werden daher auch Filter verwendet, die im Bildraum eine geringere Verschmierung hervorrufen. Je nach Ausgestaltung des Ortsfrequenzfilters kann das beleuchtete Feld dann größer oder kleiner sein. Beispielsweise weist die Verwendung eines Mikrolinsen-Arrays hier gegenüber einem schachbrettartigen Sinusgitter Vorteile auf. Da bei der Auswertung der Messungen mittels Phase-Retrieval-Algorithmen in der Regel die optische Abbildung als Fourier-Transformation modelliert wird - rechnerisch mittels Algorithmen zur schnellen Fourier-Transformation (FFT) realisiert -, kann auf diese Weise die Genauigkeit erhöht werden. Auf diese Weise wird nur ein kleiner Ausschnitt des ortsauflösenden Detektors verwendet, an dessen Rändern sich das Abbild ohne Phasensprung tatsächlich periodisch fortsetzt.

Während bei Verwendung einer Leuchtfeldblende das Bild bzw. die Bilder bereits so aufgenommen werden, daß die Bilddaten periodischen Randbedingungen genügen - d.h. beispielsweise bei einer rechteckigen CCD-Fläche des Kamerasensors der Detektierungseinrichtung, daß die aufgenommenen Intensitätswerte an einander gegenüberliegenden Bildrändern einander entsprechen bzw. ihr Verlauf über den Randbereich durch eine stetige Funktion beschrieben werden kann - so lassen sich periodische Randbedingungen auch nach Aufnahme bzw. Erzeugung des Bildes erzeugen, ohne eine Leuchtfeldblende verwenden zu müssen. Dazu wird auf die Bildpunkte eines jeden Bildes nach der Erzeugung eine Intensitätsgewichtungsfunktion angewendet, die die Intensitätswerte derart verändert, daß der Verlauf der Intensität im Bild bei periodischer Fortsetzung des Bildes einer stetigen, bevorzugt stetig differenzierbaren Funktion entspricht.

Eine Möglichkeit, die Intensitätsgewichtungsfunktion zu bestimmen, besteht zum Beispiel darin, zwischen den Werten von einander gegenüberliegenden Bildrändern zu interpolieren. Eine andere Möglichkeit besteht darin, die Intensitätswerte mit einer Gewichtungsfunktion zu multiplizieren, die überall den Wert 1 hat, außer am Rand, wo sie stetig gegen null oder einen anderen vorgegebenen Wert geht. Die Intensitätsgewichtungsfunktion kann auch über den Bildrand hinaus reichen, so daß es zu einem Überlapp der beiden Randbereiche einander gegenüberliegender Ränder kommt. Als Funktionen eignen sich im einfachsten Fall Geraden mit einer vorgegebenen Steigung, diese sind dann nur stetig. An den Ansatzpunkten, d.h. an den Punkten, wo die Intensitätsgewichtungsfunktion vom Wert 1 anfängt auf 0 zurückzugehen und an dem Punkt, wo sie 0 wird, ist die Funktion dann zwar stetig, die Ableitung ist allerdings nicht stetig. Aus rechentechnischen Gründen, insbesondere für die Genauigkeit der Berechnungen, ist es jedoch vorteilhaft, wenn die Intensitätsgewichtungsfunktionen in diesen Bereichen auch stetig differenzierbar ist, d.h. daß mindestens ihre erste Ableitung ebenfalls stetig ist. In diesem Fall läßt sich beispielsweise anstelle einer Geraden eine Viertel-Periode einer quadratischen SinusFunktion - wie z.B. a*sin²(bx) - verwenden, die an ihren jeweiligen Scheitelpunkten an die konstanten Niveaus der Gewichtungsfunktion angesetzt wird.

Dabei ist es auch möglich, daß zu den ursprünglichen Bildpunkten weitere Bildpunkte hinzukommen, beispielsweise durch eine Interpolation. Genauso können auch Bildpunkte wegfallen, beispielsweise durch die Erzeugung einer Überlappung.

Zur weiteren Verarbeitung der Bildpunkte wird dann in der Regel eine Transformation in den Frequenzraum durchgeführt. Um periodische Randbedingungen zu erzeugen, kann auch - alternativ oder in Ergänzung zur Anwendung der Intensitätsgewichtungsfunktion auf die Bildpunkte eines jeden Bildes nach der Erzeugung und nach dieser Transformation in den Frequenzraum - auf die in den Frequenzraum transformierten Bildpunkte eine Pupillengewichtungsfunktion angewendet werden, die am Rand einer Pupille nach außen stetig, bevorzugt stetig differenzierbar auf Null abfällt.

Nachdem die Intensitätsgewichtungsfunktion auf die Bildpunkte angewendet wurde - entsprechend der vorangegangenen Beschreibung besteht diese Anwendung also beispielsweise in einer Interpolation, oder einer Multiplikation, oder auch in einer Multiplikation mit einer Addition, wobei die vorangehend beschriebenen Funktionen nur Beispiele darstellen und eine große Zahl hier nicht genannter Funktionen sich ebenfalls eignet, um das gewünschte Ergebnis zu erzielen - wird auf die Bildpunkte eine Transformation in den Frequenzraum angewendet, d.h. eine Frequenzanalyse durchgeführt. Die Intensitätswerte bzw. Amplituden können beispielsweise mittels einer Fourier-Transformation - dazu zählen auch Abwandlungen wie die in der numerischen Mathematik verbreitete schnelle Fourier-Transformation (FFT) - in den Frequenz-Raum transformiert, man erhält eine Darstellung der im Bild auftauchenden Frequenzen im Pupillenraum. Auch andere Transformationen in den Frequenzraum sind selbstverständlich verwendbar. Üblicherweise wird im Stand der Technik auf die Frequenzdarstellung eine Pupillendefinitionsfunktion angewendet, die den Bereich der Pupille definiert. Innerhalb der Pupille nimmt diese Funktion den Wert 1 an, außerhalb den Wert 0. Am Rand der Pupille springt die Funktion von 1 auf 0. Diese Funktion wird erfindungsgemäß modifiziert: Statt der einfachen Pupillendefinitionsfunktion oder in Ergänzung dazu wendet man auf die Fourier-transformierten Bildpunkte eine Pupillengewichtungsfunktion an, die am Rand der Pupille stetig, bevorzugt stetig differenzierbar auf 0 abfällt. Der Sprung am Rand der Pupille wird also mindestens durch eine stetige Funktion ersetzt. Dabei wird die Pupille bevorzugt nach außen fortgesetzt, d.h. bis zum Rand der Pupille nimmt die Pupillengewichtungsfunktion den Wert 1 an, um außerhalb schneller oder langsamer auf 0 abzufallen. Im einfachsten Fall läßt sich hier eine Gerade mit vorgegebener Steigung verwenden, diese ist dann an den Ansatzpunkten, d.h. einmal am Pupillenrand, wo die Gewichtungsfunktion - in Richtung nach außen betrachtet - letztmalig den Wert 1 annimmt, sowie außerhalb, wo sie das erste Mal den Wert 0 annimmt, zwar stetig, jedoch ist die Ableitung nicht stetig. Aus rechentechnischen Gründen verwendet man daher auch andere Funktionen, die mindestens am Pupillenrand stetig differenzierbar sind. Beispielsweise kann man eine nach unten geöffnete Parabel verwenden. Auch hier lassen sich wieder Viertelperioden von Sinus- oder Kosinus-Schwingungen verwenden, so daß die Funktion in jedem Fall stetig differenzierbar wird. Auch ist es möglich, die Funktion außerhalb der Pupille ein bestimmtes Stück weit konstant fortzusetzen, bevor sie dann stetig gegen 0 abfällt.

Auf diese Weise läßt sich eine Periodizität herstellen, die es ermöglicht, periodische Randbedingungen zu simulieren, ohne eine Leuchtfeldblende verwenden zu müssen. Die Fourier-Transformation, die implizit periodische Randbedingungen verwendet, läßt sich auf diese Weise anwenden, ohne daß es zu größeren Abweichungen kommt, da durch die Anwendung mindestens einer der Gewichtungsfunktionen auch bei real nicht-periodischen Randbedingungen solche simuliert werden.

Die vorangehend beschriebenen Schritte der Anwendung einer Intensitätsgewichtungsfunktion vor der Transformation in den Frequenzraum und / oder der Anwendung einer Pupillengewichtungsfunktion auf die Bildpunkte im Frequenzraum ist dabei nicht auf die Verwendung im erfindungsgemäßen Verfahren zur ortsaufgelösten Bestimmung der Phase beschränkt, sondern läßt sich vielmehr selbstverständlich auch auf Bilder, die mit Emulationsanordnungen zur Emulation des Verhaltens von Photolithographiemasken beim Einsatz erzeugt wurden, verwenden. Diese Anordnungen, beispielsweise das AIMS der Carl Zeiss SMS GmbH, nehmen Luftbilder einer Photolithographiemaske auf, wie sie auf den Photolack wirken würde. Diese Luftbilder werden dann analysiert. In das Analyseverfahren lassen sich die vorangehend beschriebenen Schritte ohne weiteres einbauen und führen so zu einem Gewinn an Genauigkeit.

In einer weiteren Ausgestaltung des Verfahrens werden weitere Bilder erzeugt, wobei zusätzlich der Einfallswinkel des Lichts auf das Objekt variiert wird. Die Beleuchtungseinrichtung generiert eine im wesentlichen punktförmige, kohärente Beleuchtung. Zur Beleuchtung des Einfallswinkels wird dieser Beleuchtungsfleck in einer Pupillenebene des Beleuchtungssystems lateral verschoben. Alternativ kann in einer Feldebene der Beleuchtungseinrichtung der Beleuchtungswinkel durch zueinander drehbare Keile gekippt werden. Auch ein Drehen der gesamten Beleuchtungseinrichtung auf einem Kreisbogen mit einem Mittelpunkt auf der optischen Achse ist denkbar. Diese Ausgestaltung des Verfahrens kann beispielsweise dazu verwendet werden, die teilkohärente Beleuchtung eines Photolithographiescanners zu vermessen bzw. zu simulieren. Dazu werden sequentiell einzelne Bilder aufgenommen, bei denen die zu simulierende Beleuchtungspupille jeweils variiert wird. Anschließend werden die einzelnen Phasen- und Amplitudenbilder algorithmisch zusammengesetzt. Dabei werden die einzelnen Messungen in der Pupillenebene nach Zentrierung der Beugungsspektren der einzelnen Messungen auf eine Nullfrequenz per Nachbearbeitung zu einem elektromagnetischen Feld zusammengefaßt und per Simulation in die Bildebene propagiert.

In einer weiteren Ausgestaltung der Erfindung werden weitere Bilder erzeugt, wobei das Objekt mit Licht einer vorgegebenen Polarisation beleuchtet wird und das Licht polarisationsabhängig detektiert wird. Dies kann durch Einbringen eines Polarisators zwischen Beleuchtungseinrichtung und Objekt und eines Analysators zwischen Objekt bzw. Abbildungsoptik und Bildebene erreicht werden, wobei Bilder bei verschiedenen Stellungen von Polarisator und Analysator zueinander und ggf. auch zur Beleuchtungseinrichtung erzeugt werden. Auf diese Weise läßt sich bei bekannten Polarisationseigenschaften des Abbildungsobjektivs auf die polarisationsabhängige Wirkung des Objekts auf Phase und Amplitude schließen, sowie das vektorielle elektrische Feld in Pupillen- und Bildebene bestimmen.

Diese Ausgestaltung der Erfindung kann insbesondere bei der Herstellung von Photolithographiemasken und der Optimierung des Photolithographieprozesses angewendet werden. Bei der Einstellung werden der Beleuchtungswinkel, die jeweilige Polarisation und die numerische Apertur gleich denen eines Photolithographiescanners gewählt. Bei der Wahl der Apertur ist dabei allerdings auch eine größere Apertur denkbar, sofern das vermessene Objektbeugungsspektrum nach der Messung mit einer Aperturmaske des gewünschten Durchmessers multipliziert und anschließend weiterverarbeitet wird. Mit dieser Einstellung werden die scanner-relevante Phase und Amplitude vermessen.

Das Ergebnis der Messungen kann bei der Herstellung von Photolithographiemasken genutzt werden, den Herstellungsprozeß der Maske so zu optimieren, daß die Maske eine scannerrelevante Phase von 180° erzeugt.

Schließlich ist es zweckmäßig, die Möglichkeit vorzusehen, Phase und/oder Amplitude des Lichts zusätzlich durch eine Defokussierung zu modifizieren. Diese kann auch zur Eichung des Ortsfrequenzfilters herangezogen werden.

Um die Genauigkeit des Verfahrens zu erhöhen, ist es außerdem zweckmäßig, vor der ortsaufgelösten Bestimmung der Phase eine Kalibrierung in bezug auf die monochromatischen Abberationen durchzuführen. Dazu wird ein phaseninaktives Objekt, dessen Strukturen bekannt sind - beispielsweise ein Chrom-auf-Glas-Pinhole oder auch ein Pinhole-Array zur Mittelung über das gesamte, abgebildete Bildfeld - verwendet, wobei die Beugung an den Objekten ausreichend große Winkel erzeugt, um die gesamte numerische Apertur auszuleuchten. Das Objekt wird dann entweder mittels Defokussierung oder unter Verwendung des Pupillenfilters vermessen und es werden verschiedene Intensitätsbilder erzeugt. Diese werden anschließend mit dem Phase-Retrieval-Algorithmus ausgewertet. Die für die Pupillenebene berechnete Phase bzw. Phasenverteilung entspricht dann den monochromatischen Abberationen. Sie wird bei jeder Messung von der berechneten Phase der Messung in der Pupillenebene abgezogen, wobei die Phase numerisch beispielsweise als Reihenentwicklung nach Zernike-Polynomen und - Koeffizienten gespeichert wird. Vektorielle Abberationseffekte lassen sich berücksichtigen, indem die Messung für verschiedene Polarisationsrichtungen bei der Beleuchtung und der Analyse durchgeführt wird.

Eine weitere Verbesserung der Genauigkeit läßt sich erreichen, indem vor der Erzeugung bzw. Aufnahme der Bilder eine Kalibrierung zur Kompensation zufälliger Defokussierungen durchgeführt wird. Diese Defokussierungen treten während der Messung auf und sind zeitlich veränderlich, so daß diese Kalibrierung bevorzugt vor der Erzeugung eines jeden Bildes erneut durchgeführt wird. Wird die Phase der Wellenfront bei der Abbildung eines unbekannten Objektes in der Pupille nach Polynomen entwickelt, so tritt in dieser Entwicklung ein quadratischer Term auf, falls eine Defokussierung vorliegt. Der Koeffizient des quadratischen Terms läßt sich dann extrahieren und der Term somit von der Phase in der Pupille abziehen. Auch andere, ähnliche Strategien zur Berücksichtigung des quadratischen Phasenterms zur Kalibrierung der Defokussierung sind anwendbar.

Die Erfindung betrifft auch eine Vorrichtung zur aufgelösten Bestimmung der Phase und Amplitude des elektromagnetischen Feldes in der Bildebene einer Abbildung eines Objektes. Für eine solche Vorrichtung der eingangs beschriebenen Art wird die Aufgabe dadurch gelöst, daß bei der Abbildungsoptik ein in den Strahlengang in eine Pupillenebene einkoppelbarer Ortsfrequenzfilter vorgesehen ist, mit dem die Phase und/oder Amplitude des Lichts modifiziert wird, wobei die Vorrichtung ein erstes Bild und mindestens ein weiteres Bild erzeugt, wobei die Phase und / oder die Amplitude des Lichts in vorgegebener Weise durch den Ortsfrequenzfilter modifiziert werden und die Modifikation sich für ein jedes Bild von denen für die übrigen Bilder unterscheidet. Das erste Bild kann dabei mit aus- oder eingekoppeltem Ortsfrequenzfilter erzeugt werden. Gemäß der Erfindung werden mindestens zwei Bilder mit eingekoppeltem Filter erzeugt, basierend auf einer Anordnung, in der der Filter beweglich bzw. in seiner Stellung im Strahlengang veränderbar angeordnet ist, d.h. es muß mindestens eine zweite Stellung des Filters möglich sein, damit die Bilder unter verschiedenen Bedingungen aufgenommen werden können. Gemäß einer nicht unter den Schutzumfang der Ansprüche fallenden Anordnung ist auch ein Wechsel zwischen zwei verschiedenen Filtern denkbar, diese müssen dann nicht beweglich sein. Das Auswertemodul verarbeitet dann die gespeicherten Bilder und bestimmt ortsaufgelöst die Phase in der Abbildung des Objektes in der Bildebene. Durch die Verwendung eines Ortsfrequenzfilters läßt sich gegenüber herkömmlichen Anordnungen zur Phasenbestimmung, die mittels des Prinzips der Defokussierung arbeiten, eine Verbesserung der Genauigkeit erzielen, außerdem stehen verschiedene Möglichkeiten zur Verfügung, Phase und/oder Amplitude zu modifizieren. So können ein oder mehrere Ortsfrequenzfilter vorgesehen sein, von denen einer beispielsweise nur die Phase, ein anderer nur die Amplitude, und ein dritter beides modifiziert, jeweils in unterschiedlichen Frequenzbereichen. Im Auswertemodul ist zur Verarbeitung der Bilder dann ein Phase-Retrieval-Algorithmus, beispielsweise nach Gerchberg und Saxton, implementiert, mit dem die Phase der Wellenfront in der Bildebene iterativ bestimmt wird. Mittels der erfindungsgemäßen Vorrichtung läßt sich das vorangehend beschriebene Verfahren durchführen. Gegenüber dem Stand der Technik läßt sich eine schnellere Konvergenz bei der Lösung des entsprechenden, iterativen Gleichungssystems erzielen.

Der eingekoppelte Ortsfrequenzfilter ist um die optische Achse und/oder eine zur optischen Achse senkrechte Drehachse die die optische Achse schneidet, rotierbar und/oder senkrecht zur optischen Achse verschiebbar angeordnet. Im eingekoppelten Zustand kann der Ortsfrequenzfilter zum einen um die optische Achse rotiert werden, gegen die optische Achse gekippt werden oder auch lateral verschoben werden. Auf diese Weise steht eine Vielzahl von Eingriffmöglichkeiten in den Strahlengang zur Verfügung, das Ortsfrequenzspektrum kann so auf vielfache Weise modifiziert werden. Auch andere Verschiebungen, Kippungen oder Rotationen sind denkbar. Voraussetzung ist dabei, daß die Abbildungsoptik im wesentlichen durch Fourier-Transformation modelliert werden kann, d.h. die Abbildungsoptik näherungsweise einer Fourier-Transformations-Optik entspricht. Das Beugungsspektrum bzw. Beugungsbild des Objekts wird durch ein hochauflösendes Objektiv aufgefangen und Fourier-transformiert. Durch die abbildende Optik wird die Amplitudenverteilung im Beugungsbild in das Ortsfrequenzspektrum der Amplitudenverteilung im beugenden Objektiv Fourier-transformiert. Durch entsprechende, ortsfrequenzselektive Eingriffe wird dieses Spektrum nun in Phase und/oder Amplitude manipuliert und so die Amplitudenverteilung und / oder Phasenverteilung im Beugungsbild verändert.

Bei der Abbildung des Objektes in die Bildebene macht sich dies entsprechend durch Intensitätsveränderungen bemerkbar.

Zweckmäßig erzeugt die Vorrichtung eine Vielzahl von Bildern bei jeweils unterschiedlichen Stellungen des mindestens einen Ortsfrequenzfilters. Auf diese Weise steht ein großer Datensatz zur Verfügung, die Meßgenauigkeit wird erhöht und die Konvergenz beschleunigt. Mindestens jedoch sind zwei Bilder notwendig.

Als ein Ortsfrequenzfilter ist bevorzugt eine Einzellinse, ein Mikrolinsen-Array, ein Siemensstern, ein Spiralfilter, ein Transmissionsgitter oder auch ein Phasengitter vorgesehen. Bevorzugt werden dabei solche Ortsfrequenzfilter verwendet, die die nullte Beugungsordnung nicht ausblenden, da so eine höhere Genauigkeit erzielt werden kann. Im Falle eines Mikrolinsen-Arrays erhält man eine vielfältige Manipulationsmöglichkeit - bei meist symmetrischen Beugungsspektren -, wenn die Positionen der Einzellinsen auf dem Array nicht regelmäßig, sonder statistisch gestreut und / oder aperiodisch verteilt sind.

Bevorzugt ist bei der Vorrichtung in einer Objektebene im Strahlengang der Beleuchtungseinrichtung eine Leuchtfeldblende angeordnet. Auf diese Weise kann das tatsächliche Abbildungsverhalten noch näher an das ideale Abbildungsverhalten mittels Fourier-Transformation herangeführt werden, d.h. die Abweichungen zwischen dem Modell, basierend auf Fourier-Transformationen und der realen Vorrichtung werden verringert.

Schließlich kann auch vorgesehen sein, daß der Halter entlang der optischen Achse verschiebbar ist. Auf diese Weise läßt sich auch die klassische Methode der Defokussierung - beispielsweise zur Kontrolle oder zur Kalibrierung - bei der Phasenbestimmung in der Bildebene einsetzen.

Vorzugsweise sind außerdem Einstellmittel zur Einstellung des Einfallswinkels des Beleuchtungslichts auf das Objekt vorgesehen. Der durch die Beleuchtungseinrichtung generierte kohärente Beleuchtungspunkt wird durch diese Einstellmittel lateral in einer Pupillenebene der Beleuchtungseinrichtung verschoben. Bevorzugt sind dazu zwei gegeneinander bewegliche optische Elemente vorgesehen, beispielsweise zwei gegeneinander verdrehbare Drehkeile, die in einer Feldebene einen Winkel erzeugen. Eine andere Möglichkeit besteht in der Verwendung zweier kippbarer Planplatten, die in der Puppillenebene einen Lateralversatz erzeugen.

In einer bevorzugten Ausgestaltung der Erfindung ist zwischen der Beleuchtungseinrichtung und Objekt ein Polarisator und zwischen Abbildungsoptik und Detektor ein Analysator angeordnet. Auf diese Weise kann das unbekannte Objekt mit Licht einer definierten Polarisationsrichtung beleuchtet werden, die Intensität wird dann durch Verwendung des Analysators in verschiedenen Stellungen vor dem Detektor polarisationsabhängig detektiert. Auch die Stellung des Polarisators kann selbstverständlich verändert werden. Unter der Annahme des skalaren Verhaltens des Abbildungssystems zwischen Pupillen- und Bildebene, d.h. der Voraussetzung kleiner Abbildungswinkel kann ein skalarer Phase-Retrieval-Algorithmus zur Rekonstruktion der Phase und Amplitude im Pupillen- und Bildraum angewendet werden. Voraussetzung ist, daß man die Polarisationseigenschaften des Abbildungsobjektivs, d.h. dessen Jones-Matrix, kennt. Nach der Verrechnung der Jones-Matrix des Abbildungssystems läßt sich auf diese Weise direkt auf die polarisationsabhängige Wirkung des Objekts auf Phase und Amplitude schließen. Wiederholt man diese Schritte für verschiedene Richtungen der Polarisation bei der Beleuchtung, d.h. verschiedene Stellungen des Polarisators, so läßt sich auf das vektorielle elektrische Feld in Pupillen- und Bildebene rückschließen. Zusätzlich kann natürlich auch der Beleuchtungswinkel variiert werden. Auf diese Weise läßt sich beispielsweise die Jones-Matrix einer Photolithographiemaske bestimmen. Um das Abbildungsverhalten eines Photolithographiescanners zu simulieren, entsprechen die optischen Eigenschaften der Abbildungsoptik, d.h. ihre Übertragungsfunktion, bevorzugt im wesentlichen denen des zu simulierenden Photolithographiescanners im Hinblick auf die numerische Apertur; die optischen Eigenschaften der Beleuchtungseinrichtung entsprechen ebenfalls bevorzugt im wesentlichen denen des zu simulierenden Scanners, was Beleuchtungswinkel und / oder Polarisation betrifft. Auch weitere Eigenschaften können entsprechend gewählt werden. Alternativ kann auch die numerische Apertur der Abbildungsoptik größer als die numerische Apertur des zu simulierenden Photolithographiescanners gewählt werden. In einem weiteren Verarbeitungsschritt wird dann das in der Pupillenebene, d.h. einer zur Bildebene konjugierten Ebene, bestimmte elektromagnetische Feld durch Multiplikation mit einer Aperturmaske, die im Durchmesser der Apertur des Scanners entspricht, weiterverarbeitet.

Diese Vorgehensweise eignet sich besonders zur Vermessung der polarisierenden Eigenschaften von Photolithographiemasken. Da sich auf diese Weise das elektrische Feld des Beugungsspektrums einer solchen Maske vektoriell bestimmen läßt, eignet sich die erfindungsgemäße Vorrichtung besonders gut zur Simulation des Abbildungsverhaltens eines PhotolithographieScanners, unter Verwendung der vermessenen elektromagnetischen Felder. Bei Strukturbreiten und -tiefen auf der Photolithographiemaske in der Größenordnung der Beleuchtungswellenlänge und kleiner können rigorose Effekte der Beugung auf der Maske nicht mehr vernachlässigt werden. Gängige rigorose Simulatoren, die die Maxwell-Gleichungen lösen, beispielsweise basierend auf Finite-Elemente-Methoden, zeigen Schwankungen der Ergebnisse in Abhängigkeit der verwendeten Modelle. Sie benötigen daher Eingangsdaten der dreidimensionalen Geometrie der Maske, welche nur indirekt und mit großem Aufwand abgeleitet werden können. Mittels der Meßergebnisse der erfindungsgemäßen Vorrichtung kann das partiell kohärente Abbild eines Scanners unter Berücksichtigung der vektoriellen Effekte der Photolithographiemaske und des Photolithographiescanners mittels der Hopkins'schen Theorie simuliert werden. Das durch die Vorrichtung bestimmte elektrische Feld des Beugungsspektrums enthält sämtliche Informationen über die rigorosen Effekte der Maske. Auf eine rigorose Simulation kann somit verzichtet werden.

Darüber hinaus kann die Verschiebung des kohärenten Beugungsspektrums bei senkrechtem Einfall für die verschiedenen Beleuchtungswinkel der partiell kohärenten Beleuchtung in der Hopkins'schen Simulation durch Verrechnung der gemessenen bzw. interpolierten Beugungsspektren, die unter verschiedenen Beleuchtungswinkeln erzeugt wurden, bestimmt werden.

Auf diese Weise kann die Simulation verbessert werden. Bei der Simulation des Scanners können verschiedene Eigenschaften berücksichtigt werden, beispielsweise die Jones-Matrix des Scanners, Aberrationen, sogenanntes Flare, die natürliche Apodisation und die Schichtapodisation des Scanners, der Brechungsindex einer optionalen Immersionsflüssigkeit sowie der Fresnelreflex am Übergang von Immersionsflüssigkeit/Luft zum Photolack bzw. der Antireflex-Beschichtung. Auch die zeitliche und räumliche Kohärenzfunktion des Beleuchtungssystems des Scanners kann bei der Scannersimulation berücksichtigt werden.

Für Strukturgrößen in der Nähe der verwendeten Wellenlänge und des Auflösungsvermögens hängt die Phase bei der Belichtung stark vom Einfallswinkel des Beleuchtungslichts, der Polarisation des Beleuchtungslichts sowie der Apertur ab. Um die Phase zu bestimmen, die beim Photolithographiescanner auftritt, muß die Beleuchtung des Scanners - u.U. durch sequentielle Messungen verschiedener Beleuchtungswinkel zur Interpolation beispielsweise einer Dipolbeleuchtung - und die Abbildungsapertur des Scanners möglichst genau nachgebildet werden, was mit der erfindungsgemäßen Vorrichtung gelingt. Bezüglich der Apertur ist dabei auch die Messung mit einer höheren Apertur möglich, das registrierte Beugungsspektrum kann mittels spezieller Algorithmen nachträglich beschnitten werden. Die gemessene bzw. nach der Verarbeitung ausgegebene Phase repräsentiert dann scannerrelevante optische Einstellungen und entspricht etwa der Phase, die beim Scanner beim Belichtungsprozeß auftritt. Optimiert man den Herstellungsprozeß einer Maske für die Photolithographie, so daß sie beispielsweise eine Phase von 180 Grad oder einen vorgegebenen Wert erzeugt, so hat man eine optimale Maske hergestellt. Der Herstellungsprozeß kann mit diesen, aufgrund der Simulation erhaltenen Parametern optimiert werden, d.h. an die gewünschten Eigenschaften angepaßt und entsprechend eingestellt werden, so daß bei der Abbildung der Photolithographiemaske in die Bildebene dort an durch die Maskenstruktur vorgegebenen Stellen einen Phasensprung von 180° erzeugt wird. Die Herstellung von Phasenlithographiemasken kann auf diese Weise auch überwacht werden.

Anstatt den Herstellungsprozeß für die kostenintensiven Masken zu optimieren kann auch der umgekehrte Weg beschritten werden, d.h. für eine gegebene Maskenstruktur wird das Abbildungsverhalten des Photolithographiescanners optimiert, d.h. angepaßt und eingestellt, so daß in der Bildebene dort an den durch die Maskenstruktur vorgegebenen Stellen ein Phasensprung von 180° erzeugt wird. Dabei wird die Propagation des elektromagnetischen Beugungsspektrums der Maske in die Bildebene simuliert, wobei die optischen Abbildungs- und Beleuchtungseigenschaften des Scanners so gut wie möglich berücksichtigt werden. Anhand der Auswertung der simulierten Bilder können dann diese Eigenschaften in bezug auf die spezielle Maskenstruktur für den Photolithographieprozeß eingestellt und auf diese Weise optimiert werden.

Eine weitere Verwendungsmöglichkeit der erfindungsgemäßen Vorrichtung liegt in der Bestimmung der räumlichen Struktur einer Photolithographiemaske. Zur Rückgewinnung von Informationen über die dreidimensionale Struktur einer solchen Maske sowie ihrer Materialeigenschaften werden die polarisations- und beleuchtungswinkelabhängigen vektoriellen Felder des Beugungsspektrums der Maske genutzt, um Parameter zur Beschreibung dieser Maske iterativ zu optimieren, bis ein rigoros simuliertes Beugungsspektrum dem gemessenen und gespeicherten Spektrum unter verschiedenen Meßkonfigurationen entspricht. Da viele Masken das gleiche Beugungsbild erzeugen, ist es hier notwendig, möglichst viele Informationen zu haben. Auf diese Weise kann auf den komplexen Brechungsindex des Schichtsystems der Maske, die Schichtdicke und die Kantensteilheit der Maske geschlossen werden.

### Kurze Beschreibung der Zeichnungen

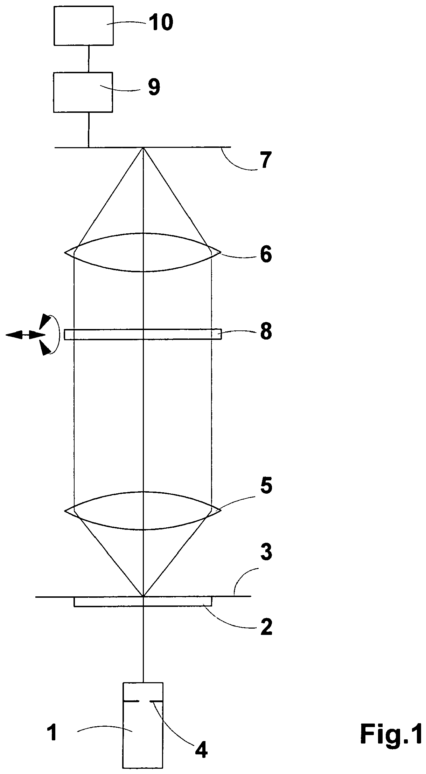

Die Erfindung soll im folgenden anhand eines Ausführungsbeispiels näher erläutert werden. In den dazugehörigen Zeichnungen zeigt
- Fig.1: den beispielhaften Aufbau einer solchen Vorrichtung und
- Fig.2: einen beispielhaften Verfahrensablauf in der Anwendung.

### Ausführliche Beschreibung der Zeichnungen

Die Vorrichtung umfaßt zunächst eine Beleuchtungseinrichtung 1. Diese Beleuchtungseinrichtung sendet kohärentes Licht aus. Als Lichtquelle ist bevorzugt ein Laser vorgesehen. Licht aus der Beleuchtungseinrichtung 1 wird auf ein Objekt 2 gestrahlt, bei dem es sich beispielsweise um eine Photolithographiemaske handeln kann. Die der Beleuchtungseinrichtung 1 abgewandte Seite des Objektes 2 liegt in einer Fokusebene 3 einer Abbildungsoptik. Bei der Beleuchtungseinrichtung 1 ist eine Leuchtfeldblende 4 vorgesehen, die das beleuchtete und abgebildete Areal verkleinert, so daß die Abweichungen der tatsächlichen Abbildung von der durch eine Fourier-Transformation modellierten Abbildung verringert werden. Außerdem können - nicht gezeigt - Einstellmittel zur Einstellung des Lichteinfallswinkels auf das Objekt 2 vorgesehen sein. Dies läßt sich beispielsweise erreichen, indem der durch die Beleuchtungseinrichtung 1 erzeugte Beleuchtungsfleck in einer Pupillenebene der Beleuchtungseinrichtung lateral verschoben wird. Alternativ kann auch die Beleuchtungseinrichtung 1 beispielsweise auf einem Kreisbogen, mit dem Mittelpunkt des Schnittpunkts der optischen Achse mit der Fokusebene 3, verfahren werden.

Das vom Objekt 2 abgestrahlte und gebeugte Licht wird durch ein hochauflösendes Objektiv aufgefangen, die Abbildung des Objektes wird dann stark nachvergrößert, beispielsweise mit einem 450fachen Abbildungsmaßstab. Die Abbildungsoptik ist hier beispielhaft als ein System von zwei Linsen 5 und 6 dargestellt, in der Regel wird sie jedoch mehr als zwei Linsen umfassen. Durch die Abbildungsoptik wird das Licht auf einen ortsauflösenden Detektor 7 abgebildet. Dort wird es registriert, die Intensitäten bestimmt und in Bildpunkten abgespeichert. Die Bildpunkte eines Meßvorgangs werden dann entsprechend einem Bild zugeordnet. In einer Pupillenebene der Abbildungsoptik - im gezeigten Beispiel also zwischen den Linsen 5 und 6 - ist außerdem ein Ortsfrequenzfilter 8 angeordnet. Dieser Ortsfrequenzfilter 8 kann vollständig aus dem Strahlengang entfernt werden. Die Vorrichtung nimmt dann ein erstes Bild auf, wobei der Ortsfrequenzfilter 8 vollständig aus dem Strahlengang ausgekoppelt ist. Anschießend wird mindestens ein weiteres Bild mit eingekoppelten Ortsfrequenzfilter 8 erzeugt. Die Bildpunkte der beiden Bilder werden jeweils in einem Speichermodul 9 als Bilder gespeichert. Von dort werden sie an ein Auswertemodul 10 weitergegeben, in dem aus den beiden Bildern mittels eines Phase-Retrieval-Algorithmus die Phase der Abbildung des Objektes in die Bildebene, in der sich der Detektor 7 befindet, berechnet wird.

Dabei werden weitere Bilder bei verschiedenen Stellungen des Ortsfrequenzfilters 8 aufgenommen. Der Ortsfrequenzfilter 8 kann dazu senkrecht zur optischen Achse lateral verschoben oder um eine Achse senkrecht zur optischen Achse, welche bevorzugt die optische Achse schneidet, gekippt werden. Diese beiden Bewegungen sind durch die Pfeile oberhalb des Ortsfrequenzfilters 8 in der Zeichnung angedeutet. Zusätzlich kann der Ortsfrequenzfilter 8 auch um die optische Achse als Rotationsachse gedreht werden. Auf diese Weise ist eine Vielzahl von Einstellungen möglich, eine genaue und schnell konvergente, iterative Bestimmung der Phase der Wellenfront in der Bildebene ist auf diese Weise möglich. Auch können mehre Ortsfrequenzfilter 8 verwendet werden, die sich beispielsweise in ihrer Frequenzselektivität unterscheiden. Schließlich kann zwischen Beleuchtungseinrichtung 1 und Objekt 2 ein - nicht gezeigter - Polarisator und zwischen der Linse 6 und dem Detektor 7 - ebenfalls nicht gezeigter - Analysator angeordnet sein.

Durch verschiedene Stellungen von Polarisator und Analysator zueinander lassen sich Bilderserien erzeugen, die zur Bestimmung des vektoriellen elektrischen Feldes in der Pupillenebene und damit auch der Bildebene verwendet werden können. Diese Bestimmung kann ebenfalls im Auswertemodul 10 erfolgen. Der Ortsfrequenzfilter 8 kann beispielsweise als Mikrolinsen-Array ausgestaltet sein. Vor der Messung können entsprechende Kalibrierungen durchgeführt werden.

Mit der beschriebenen Vorrichtung läßt sich nicht nur die Phase einer Wellenfront in der Bildebene rekonstruieren, sondern ebenfalls ein Photolithographie-Scanner simulieren. Auch kann mittels der Vorrichtung, sofern genügend Daten vorliegen, auf die Struktur des Objektes, insbesondere einer Photolithographie-Maske zurückgeschlossen werden.

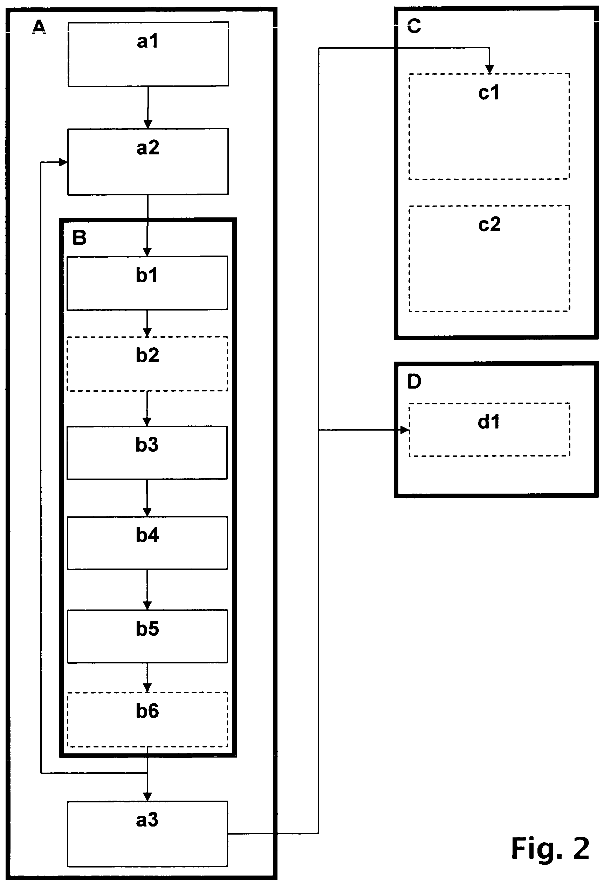

In Fig.2 sind die wesentlichen Verfahrensschritte dargestellt, die für die Simulation eines Photolithographiescanners oder die Berechnung der räumlichen Struktur einer Photolithographiemaske durchgeführt werden. Im äußeren linken, mit A gekennzeichneten Kasten sind die Schritte dargestellt, die anfangs durchgeführt werden, um die Eingangsdaten für die Simulation des Photolithographiescanners zu generieren, wobei insbesondere auch eine Bestimmung der Jones-Matrix eingeschlossen ist. Im mit B gekennzeichneten Kasten sind die Schritte, die speziell zur Phasen- und Amplitudenmessung durchgeführt werden, aufgeführt.

Zunächst werden in einem Schritt a1 verschiedene Beleuchtungswinkel und verschiedene Stellungen eines Polarisators festgelegt, entweder zur Vermessung der Jones-Matrix oder zur Einstellung einer partiell kohärenten Beleuchtung, wie sie dem zu simulierenden Scanner entspricht. Man erhält auf diese Weise in Schritt a2 einen Satz von N Beleuchtungseinstellungen. Für diese N Beleuchtungseinstellungen werden dann die Verfahrensschritte b1 bis b6 durchgeführt, am Ende erhält man in einem Schritt a3 insgesamt N Phasen und Amplituden in der Pupillen- und Bildebene.

Bei der im Kasten B dargestellten Phasen- und Amplitudenmessung wird zunächst in einem Schritt b1 eine der N Beleuchtungseinstellungen bezüglich Winkel und Polarisation ausgewählt. In einem optionalen Schritt b2 können Abbildungseigenschaften, wie insbesondere die numerische Apertur eines zu simulierenden Photolithographiescanners eingestellt werden. Anschließend werden in einem Schritt b3 mehrere Intensitätsbilder mit variierender Pupillenmanipulation aufgenommen, diese werden in einem Schritt b4 ausgewertet, beispielsweise mit Hilfe eines *Phase-Retrieval*-Algorithmus. In einem Schritt b5 erhält man als Ergebnis für die vorgegebene Beleuchtungseinstellung Phase und Amplitude in der Pupillen- und Bildebene. In einem weiteren optionalen Schritt b6 kann die Pupillenamplitude und -phase nachbearbeitet werden, beispielsweise können sie mit einer Aperturmaske multipliziert werden. Dies ist dann notwendig, wenn bei der Einstellung der Abbildungseigenschaften in Schritt b2 die numerische Apertur größer als die des zu simulierenden Photolithographiescanners gewählt wurde.

Sind diese Schritte für alle N Beleuchtungseinstellungen durchgeführt, so werden in einem Schritt a3 die sich daraus ergebenden N Phasen und Amplituden in der Pupillen- und Bildebene zusammengestellt und einer weiteren Verarbeitung zugeführt, wobei es sich entweder um Simulationen zur Optimierung und Überwachung des Maskenherstellungs- oder Photolithographieprozesses - Kasten C - oder um eine Lösung des inversen Beugungsproblems - Kasten D - handelt. Die Schritte c1, c2, und d1 sind dabei als Alternativen zu verstehen.

Im Schritt c1 wird ein Photolithographiescanner im Hinblick darauf simuliert, daß der Mastenherstellungsprozeß optimiert und überwacht wird, so daß Maskenstrukturen hergestellt werden, die beim Scannen in der Bildebene Phasensprünge von 180° bewirken. Alternativ können auch in Schritt c2 mehrere Photolithographiescanner simuliert werden, wobei diese unterschiedliche Beleuchtungs- und Abbildungseigenschaften haben. Diese simulierten Photolithographiescanner werden dann ebenfalls im Hinblick auf die Erzeugung von Phasensprüngen von 180° optimiert.

Schließlich kann auch in Schritt d1 aus den in Schritt a3 zusammengestellten Daten die dreidimensionale Struktur einer Photolithographiemaske berechnet werden.

### Bezugszeichenliste

- 1: Beleuchtungseinrichtung
- 2: Objekt
- 3: Fokusebene
- 4: Leuchtfeldblende
- 5,6: Linse
- 7: Detektor
- 8: Ortsfrequenzfilter
- 9: Speichermodul
- 10: Auswertemodul

## Patentansprüche

1. Verfahren zur ortsaufgelösten Bestimmung der Phase und Amplitude des elektromagnetischen Feldes in der Bildebene einer Abbildung eines Objekts, bei dem
- Bilder erzeugt werden, indem
a. das Objekt mit kohärentem Licht einer Beleuchtungseinrichtung beleuchtet und in eine Bildebene abgebildet wird,
b. Licht in der Bildebene ortsaufgelöst in Pixeln detektiert wird,
c. wobei für jedes Pixel die Intensität des Lichts bestimmt, in Bildpunkten gespeichert wird, und die Bildpunkte einem Bild zugeordnet werden,
- zunächst ein erstes Bild, und dann weitere Bilder erzeugt werden, wobei die Phase und / oder die Amplitude des Lichts in vorgegebener Weise modifiziert werden und die Modifikation sich für ein jedes Bild von denen für die übrigen Bilder unterscheidet, und
- aus den erzeugten Bildern ortsaufgelöst die Phase in der Abbildung des Objekts in der Bildebene bestimmt wird,
- **dadurch gekennzeichnet, daß**
- die Phase und / oder die Amplitude des Lichts durch eine Ortsfrequenzfilterung durch Einbringen eines Ortsfrequenzfilters in eine Pupillenebene zwischen Objekt und Bildebene modifiziert wird, und
- der Ortsfrequenzfilter zur Modifikation von Phase und / oder Amplitude im Strahlengang um die optische Achse und / oder um eine zur optischen Achse senkrechte Drehachse, die die optische Achse schneidet, gedreht wird, und / oder senkrecht zur optischen Achse verschoben wird.

2. Verfahren nach Anspruch 1, **dadurch gekennzeichnet, daß** als Ortsfrequenzfilter eine Einzellinse, ein Siemensstern, ein Spiralfilter, ein Transmissions- oder ein Phasengitter, oder ein Mikrolinsen-Array, bevorzugt ein Mikrolinsen-Array mit aperiodisch und / oder statistisch gewählter Lage der Linsen, eingebracht wird.

3. Verfahren nach einem der Ansprüche 1 oder 2, **dadurch gekennzeichnet, daß** auf die Bildpunkte eines jeden Bildes nach der Erzeugung eine Intensitätsgewichtungsfunktion angewendet wird, die die Intensitätswerte derart verändert, daß der Verlauf der Intensität im Bild bei periodischer Fortsetzung des Bildes einer stetigen, bevorzugt stetig differenzierbaren Funktion entspricht.

4. Verfahren nach einem der Ansprüche 1 bis 3, **dadurch gekennzeichnet, daß** auf die Bildpunkte eines jeden Bildes nach der Erzeugung
- eine Transformation in den Frequenzraum angewendet wird, und
- auf die in den Frequenzraum transformierten Bildpunkte eine Pupillengewichtungsfunktion angewendet wird, die am Rand einer Pupille nach außen stetig, bevorzugt stetig differenzierbar auf Null abfällt.

5. Verfahren nach einem der Ansprüche 1 oder 2 , **dadurch gekennzeichnet, daß** in den Strahlengang in eine Objektebene der Beleuchtungseinrichtung eine Leuchtfeldblende eingebracht wird.

6. Verfahren nach einem der Ansprüche 1 bis 5, **dadurch gekennzeichnet, daß** weitere Bilder erzeugt werden, wobei zusätzlich der Einfallswinkel des Lichts auf das Objekt variiert wird und / oder das Objekt mit Licht einer vorgegebenen Polarisation beleuchtet wird und das Licht polarisationsabhängig detektiert wird.

7. Verfahren nach einem der Ansprüche 1 bis 6, **dadurch gekennzeichnet, daß** Phase und / oder Amplitude des Lichts zusätzlich durch eine Defokussierung modifiziert werden.

8. Vorrichtung zur ortsaufgelösten Bestimmung der Phase und Amplitude des elektromagnetischen Feldes in der Bildebene einer Abbildung eines Objekts, umfassend
- eine Beleuchtungseinrichtung mit einer kohärentes Licht abstrahlenden Lichtquelle, einen Halter für das Objekt, eine Abbildungsoptik, einen ortsauflösenden Detektor mit Pixeln, ein Speichermodul, sowie ein Auswertemodul,
- wobei die Vorrichtung Bilder erzeugt, indem
a. das Objekt mit dem kohärenten Licht beleuchtet und durch die Abbildungsoptik in die Bildebene abgebildet wird,
b. das Licht in der Bildebene ortsaufgelöst in den Pixeln detektiert wird,
c. wobei für jedes Pixel die Intensität des Lichts bestimmt und im Speichermodul in Bildpunkten gespeichert wird, und die Bildpunkte einem Bild zugeordnet werden,
- **dadurch gekennzeichnet, daß**
- bei der Abbildungsoptik ein in den Strahlengang in eine Pupillenebene einkoppelbarer Ortsfrequenzfilter vorgesehen ist, mit dem die Phase und / oder Amplitude des Lichts modifiziert wird,
- wobei der eingekoppelte Ortsfrequenzfilter um die optische Achse und / oder eine zur optischen Achse senkrechte Drehachse, die die optische Achse schneidet, rotierbar und / oder senkrecht zur optischen Achse verschiebbar angeordnet ist,
- die Vorrichtung ein erstes Bild mit ausgekoppeltem Ortsfrequenzfilter und weitere Bilder mit eingekoppeltem Ortsfrequenzfilter erzeugt, wobei die Phase und / oder die Amplitude des Lichts in vorgegebener Weise durch den Ortsfrequenzfilter modifiziert werden und die Modifikation sich für ein jedes Bild von denen für die übrigen Bilder unterscheidet,
- und das Auswertemodul die gespeicherten Bilder verarbeitet und ortsaufgelöst die Phase in der Abbildung des Objekts in der Bildebene bestimmt.

9. Vorrichtung nach Anspruch 8, **dadurch gekennzeichnet, daß** als Ortsfrequenzfilter eine Einzellinse, ein Mikrolinsen-Array, besonders bevorzugt ein Mikrolinsen-Array mit aperiodisch und / oder statistisch verteilten Positionen der Linsen, ein Siemensstern, ein Spiralfilter, ein Transmissions- oder ein Phasengitter vorgesehen ist.

10. Vorrichtung nach einem der Ansprüche 8 oder 9, **dadurch gekennzeichnet, daß** in einer Objektebene im Strahlengang der Beleuchtungseinrichtung eine Leuchtfeldblende angeordnet ist.

11. Vorrichtung nach einem der Ansprüche 8 bis 10, **dadurch gekennzeichnet, daß** Einstellmittel, bevorzugt umfassend zwei gegeneinander bewegliche optische Elemente umfassend, zur Einstellung des Einfallswinkels des Lichts auf das Objekt vorgesehen sind.

12. Vorrichtung nach einem der Ansprüche 8 bis 11, **dadurch gekennzeichnet, daß** zwischen Beleuchtungseinrichtung und Objekt ein Polarisator und zwischen Abbildungsoptik und Detektor ein Analysator angeordnet ist.

13. Vorrichtung nach einem der Ansprüche 8 bis 12, **dadurch gekennzeichnet, daß** die optischen Eigenschaften der Abbildungsoptik und / oder der Beleuchtungseinrichtung im wesentlichen den optischen Eigenschaften eines zu simulierenden Photolithographiescanners entsprechen.

14. Verwendung der Vorrichtung nach einem der Ansprüche 8 bis 13 zur Simulation des Abbildungsverhaltens eines Photolithographiescanners, der Bestimmung der räumlichen Struktur einer Photolithographiemaske, zur Bestimmung der Jones-Matrix einer Photolithographiemaske, zur Anpassung und Einstellung des Herstellungsprozesses einer Photolithographiemaske, so daß bei ihrer Abbildung in die Bildebene dort an durch die Maskenstruktur vorgegebenen Stellen einen Phasensprung von 180° erzeugt wird, oder zur Anpassung und Einstellung des Abbildungsverhaltens eines Photolithographiescanners für eine gegebene Photolithographiemaske, so daß bei deren Abbildung in die Bildebene dort an durch die Maskenstruktur vorgegebenen Stellen einen Phasensprung von 180° erzeugt wird.

## Claims

1. Method for the spatially resolved determination of the phase and amplitude of the electromagnetic field in the image plane of an imaging of an object, wherein
- images are generated by virtue of the fact that
a. the object is illuminated with coherent light of an illumination device and is imaged into an image plane,
b. light in the image plane is detected in a spatially resolved manner in pixels,
c. wherein for each pixel the intensity of the light is determined and stored in image points, and the image points are assigned to an image,
- firstly a first image and then further images are generated, wherein the phase and/or the amplitude of the light are/is modified in a predefined manner and the modification for each image differs from those for the rest of the images, and
- the phase in the imaging of the object in the image plane is determined from the generated images in a spatially resolved manner,
- **characterized in that**
- the phase and/or the amplitude of the light are/is modified by a spatial frequency filtering by introducing a spatial frequency filter into a pupil plane between object and image plane, and
- the spatial frequency filter for modifying phase and/or amplitude in the beam path is rotated about the optical axis and/or about a rotation axis that is perpendicular to the optical axis and intersects the optical axis, and/or is displaced perpendicularly to the optical axis.

2. Method according to Claim 1, **characterized in that** a single lens, a Siemens star, a spiral filter, a transmission or a phase grating, or a microlens array, preferably a microlens array with an aperiodically and/or statically chosen position of the lenses, is introduced as spatial frequency filter.

3. Method according to either of Claims 1 and 2, **characterized in that** an intensity weighting function is applied to the image points of each image after generation and alters the intensity values in such a way that the profile of the intensity in the image upon periodic continuation of the image corresponds to a continuous, preferably continuously differentiable, function.

4. Method according to any of Claims 1 to 3, **characterized in that** there is applied to the image points of each image after generation
- a transformation into the frequency domain, and
- a pupil weighting function is applied to the image points transformed into the frequency domain, said function falling to zero at the edge of a pupil outwardly continuously, preferably continuously differentiably.

5. Method according to either of Claims 1 and 2, **characterized in that** a luminous field stop is introduced into the beam path into an object plane of the illumination device.

6. Method according to any of Claims 1 to 5, **characterized in that** further images are generated, wherein in addition the angle of incidence of the light on the object is varied and/or the object is illuminated with light having a predefined polarization and the light is detected in a polarization-dependent manner.

7. Method according to any of Claims 1 to 6, **characterized in that** phase and/or amplitude of the light are/is additionally modified by a defocusing.

8. Apparatus for the spatially resolved determination of the phase and amplitude of the electromagnetic field in the image plane of an imaging of an object, comprising
- an illumination device having a light source that emits coherent light, a holder for the object, an imaging optical unit, a spatially resolving detector having pixels, a storage module, and an evaluation module,
- wherein the apparatus generates images by virtue of the fact that
a. the object is illuminated with the coherent light and is imaged into the image plane by the imaging optical unit,
b. the light in the image plane is detected in a spatially resolved manner in the pixels,
c. wherein for each pixel the intensity of the light is determined and stored in image points in the storage module, and the image points are assigned to an image,
- **characterized in that**
- in the case of the imaging optical unit, a spatial frequency filter that is able to be coupled into the beam path into a pupil plane is provided, the phase and/or amplitude of the light being modified by means of said spatial frequency filter,
- wherein the coupled-in spatial frequency filter is arranged such that it is rotatable about the optical axis and/or a rotation axis that is perpendicular to the optical axis and intersects the optical axis, and/or such that it is displaceable perpendicularly to the optical axis,
- the apparatus generates a first image with the spatial frequency filter coupled out and further images with the spatial frequency filter coupled in, wherein the phase and/or the amplitude of the light are/is modified by the spatial frequency filter in a predefined manner and the modification for each image differs from those for the rest of the images,
- and the evaluation module processes the stored images and determines the phase in the imaging of the object in the image plane in a spatially resolved manner.

9. Apparatus according to Claim 8, **characterized in that** a single lens, a microlens array, particularly preferably a microlens array with aperiodically and/or statistically distributed positions of the lenses, a Siemens star, a spiral filter, a transmission or a phase grating is provided as spatial frequency filter.

10. Apparatus according to either of Claims 8 and 9, **characterized in that** a luminous field stop is arranged in an object plane in the beam path of the illumination device.

11. Apparatus according to any of Claims 8 to 10, **characterized in that** setting means, preferably comprising two optical elements that are movable relative to one another, are provided for setting the angle of incidence of the light on the object.

12. Apparatus according to any of Claims 8 to 11, **characterized in that** a polarizer is arranged between illumination device and object and an analyser is arranged between imaging optical unit and detector.

13. Apparatus according to any of Claims 8 to 12, **characterized in that** the optical properties of the imaging optical unit and/or of the illumination device substantially correspond to the optical properties of a photolithography scanner to be simulated.

14. Use of the apparatus according to any of Claims 8 to 13 for simulating the imaging behaviour of a photolithography scanner, for determining the spatial structure of a photolithography mask, for determining the Jones matrix of a photolithography mask, for adapting and setting the production process for a photolithography mask, such that upon the imaging thereof into the image plane a phase jump of 180° is generated there at locations predefined by the mask structure, or for adapting and setting the imaging behaviour of a photolithography scanner for a given photolithography mask, such that upon the imaging thereof into the image plane a phase jump of 180° is generated there at locations predefined by the mask structure.

## Revendications

1. Procédé pour la détermination spatialement résolue de la phase et de l'amplitude du champ électromagnétique dans le plan image d'une image formée d'un objet, dans lequel des images sont produites
a. en éclairant l'objet avec une lumière cohérente provenant d'un dispositif d'éclairage et en en formant l'image dans un plan image,
b. en détectant la lumière dans le plan image de manière spatialement résolue en pixels,
c. dans lequel l'intensité de la lumière est déterminée pour chaque pixel, stockée dans des points d'image, et en associant les points d'image à une image,
- en générant d'abord une première image, puis d'autres images, dans lequel la phase et/ou l'amplitude de la lumière sont modifiées d'une manière prédéterminée et, pour chaque image, la modification est différente de celles des autres images, et
- en déterminant de manière spatialement résolue la phase de l'image de l'objet dans le plan image à partir des images générées,
**caractérisé en ce que**
- la phase et/ou l'amplitude de la lumière est modifiée par un filtrage de fréquence spatiale par introduction d'un filtre de fréquence spatiale dans un plan pupillaire entre l'objet et le plan image, et
- le filtre de fréquence spatiale est mis en rotation autour de l'axe optique et/ou autour d'un axe de rotation perpendiculaire à l'axe optique et qui coupe l'axe optique, et/ou déplacé perpendiculairement à l'axe optique, pour modifier la phase et/ou l'amplitude sur le chemin de faisceau.

2. Procédé selon la revendication 1, **caractérisé en ce qu'**une lentille unique, une mire de Siemens, un filtre en spirale, un réseau de transmission ou de phase, ou une matrice de microlentilles, de préférence une matrice de microlentilles qui présente une position des lentilles sélectionnée de manière apériodique et/ou statistique, est utilisé en tant que filtre de fréquence spatiale.

3. Procédé selon l'une des revendications 1 ou 2, **caractérisé en ce qu'**une fonction de pondération d'intensité est appliquée aux points d'image de chaque image après la génération, celle-ci modifiant ainsi les valeurs d'intensité de telle manière que la courbe de l'intensité dans l'image, lors d'une continuation périodique de l'image, corresponde à une fonction continue, de préférence continûment différentiable.

4. Procédé selon l'une des revendications 1 à 3, **caractérisé en ce qu'**en des points d'image de chaque image, après la génération,
- une transformation dans l'espace des fréquences est appliquée, et
- une fonction de pondération pupillaire, qui décroît continûment vers zéro, de préférence de manière différentiable, au bord de la pupille et vers l'extérieur, est appliquée aux points d'image transformés dans l'espace des fréquences.

5. Procédé selon l'une des revendications 1 ou 2, **caractérisé en ce qu'**un diaphragme de champ éclairé est introduit sur le chemin de faisceau dans un plan objet du dispositif d'éclairage.

6. Procédé selon l'une des revendications 1 à 5, **caractérisé en ce que** d'autres images sont générées, dans lequel l'angle d'incidence de la lumière sur l'objet est en outre modifié et/ou l'objet est en outre éclairé par une lumière de polarisation prédéterminée et la lumière est détectée en fonction de la polarisation.

7. Procédé selon l'une des revendications 1 à 6, **caractérisé en ce que** la phase et/ou l'amplitude de la lumière sont en outre modifiées par une défocalisation.

8. Dispositif de détermination spatialement résolue de la phase et de l'amplitude du champ électromagnétique dans le plan image d'une image d'un objet, comprenant
- un dispositif d'éclairage comportant une source lumineuse cohérente émettant de la lumière, un support destiné à l'objet, un système optique de formation d'image, un détecteur spatialement résolu comportant des pixels, un module de mémoire et un module d'évaluation,
- dans lequel l'appareil génère des images
a. en éclairant l'objet avec la lumière cohérente et en en formant l'image dans le plan image par l'intermédiaire du système optique de formation d'image,
b. en détectant la lumière dans le plan image de manière spatialement résolue dans les pixels,
c. dans lequel l'intensité de la lumière est déterminée pour chaque pixel et est stockée dans des points d'image dans le module mémoire, et les points d'image sont associés à une image,
**caractérisé en ce que**
- un filtre de fréquence spatiale, qui peut être inséré dans le chemin de faisceau dans un plan pupillaire, est prévu dans l'optique de formation d'image, au moyen duquel la phase et/ou l'amplitude de la lumière est modifiée,
- dans lequel le filtre de fréquence spatiale inséré est disposé de manière rotative autour de l'axe optique et/ou d'un axe de rotation perpendiculaire à l'axe optique et qui coupe l'axe optique et/ou de manière déplaçable perpendiculairement à l'axe optique,
- le dispositif génère une première image en découplant le filtre de fréquence spatiale et d'autres images en insérant le filtre de fréquence spatiale, dans lequel la phase et/ou l'amplitude de la lumière sont modifiées d'une manière prédéterminée par le filtre de fréquence spatiale et, pour chaque image, la modification est différente de celles des autres images,
- et en faisant en sorte que le module d'évaluation traite les images stockées et détermine de manière spatialement résolue la phase dans l'image de l'objet formée dans le plan image.

9. Dispositif selon la revendication 8, **caractérisé en ce qu'**il est prévu en tant que filtre de fréquence spatiale, une lentille unique, un réseau de microlentilles, de manière particulièrement préférée un réseau de microlentilles présentant des positions de lentilles réparties de manière apériodique et/ou statistique, une mire de Siemens, un filtre en spirale, un réseau de transmission ou un réseau de phase.

10. Dispositif selon l'une des revendications 8 ou 9, **caractérisé en ce qu'**un diaphragme de champ éclairé est disposé dans un plan objet sur le chemin de faisceau du dispositif d'éclairage.

11. Dispositif selon l'une des revendications 8 à 10, **caractérisé en ce qu'**il est prévu des moyens de réglage, comprenant de préférence deux éléments optiques mobiles l'un par rapport à l'autre, pour régler l'angle d'incidence de la lumière sur l'objet.

12. Dispositif selon l'une des revendications 8 à 11, **caractérisé en ce qu'**un polariseur est disposé entre le dispositif d'éclairage et l'objet et **en ce qu'**un analyseur est disposé entre l'optique de formation d'image et le détecteur.

13. Dispositif selon l'une des revendications 8 à 12, **caractérisé en ce que** les propriétés optiques de l'optique de formation d'image et/ou du dispositif d'éclairage correspondent sensiblement aux propriétés optiques d'un dispositif de balayage photolithographique à simuler.

14. Utilisation du dispositif selon l'une des revendications 8 à 13, destiné à simuler le comportement de formation d'image d'un dispositif de balayage photolithographique, à déterminer la structure spatiale d'un masque photolithographique, à déterminer la matrice de Jones d'un masque photolithographique, à adapter et ajuster le processus de fabrication d'un masque photolithographique, de manière à ce que, lorsque leurs images sont formées dans le plan image, un déphasage de 180° y soit généré en des points prédéterminés par la structure de masque, ou pour adapter et ajuster le comportement de formation d'image d'un dispositif de balayage photolithographique pour un masque photolithographique donné, de manière à ce que, lorsque leurs images sont formées dans le plan image, un saut de phase de 180° y soit généré en des points prédéterminés par la structure de masque.
